# EUROPEAN PATENT APPLICATION

(11) **EP 4 216 337 A1**
(43) Date of publication of application: **26.07.2023**
(21) Application number: 22152512.4
(22) Date of filing: 20.01.2022
(51) Int. Cl.: H01M 10/48, H01M 4/133, H01M 4/136, H01M 4/36, H01M 10/0525, H01M 10/0585, H01M 10/42, H01M 50/409, H01M 50/44, G01D 5/353, G01L 1/24, H01M 50/46, H01M 4/58

(54) **STRUCTURAL BATTERY FOR A VEHICLE**

(71) Applicant: Airbus Operations GmbH, 21129 Hamburg (DE)
(72) Inventor: LINDE, Peter, 21129 Hamburg (DE); NASIRI, Awista, 21129 Hamburg (DE)
(74) Representative: Isarpatent

(57) **Abstract**

A structural battery for a vehicle, in particular an aircraft or spacecraft, comprises a multi-layer fiber-composite laminate configured as an electrochemical energy storage for storing electrical energy in a rechargeable manner, wherein the laminate comprises a cathode layer, an anode layer and a separator layer separating the cathode layer from the anode layer in a permeable manner for ions transporting electric charge between the cathode layer and the anode layer, wherein the separator layer contains sensing glass fibers arranged adjacent to at least one of the cathode layer and the anode layer; and a charge state monitoring device optically coupled to the sensing glass fibers of the separator layer to readout light signals traveling through the sensing glass fibers, wherein the charge monitoring device is configured to determine a color of at least one of the cathode layer and the anode layer adjacent to the sensing glass fibers based on the readout light signals and to assess a charge state of the electrochemical energy storage based on the determined color.

## Description

The present invention pertains to a structural battery for a vehicle, in particular an aircraft or spacecraft.

Although applicable in a wide variety of applications, the present invention and the underlying problem will be explained in more detail with reference to passenger aircraft. However, the methods and devices described can also be used in various vehicles and in all areas of the transport industry, for example for road vehicles, for rail vehicles, for aircraft and/or for water vehicles.

It has been increasingly proposed in the aerospace sector to incorporate electrical energy storage systems into the fiber composite structure of an aircraft in order to reduce weight, for example by constructing electrochemical cells from functional multilayer laminates, which are then integrated into the layered fiber composite structure of the aircraft components. For structural composite batteries, such as lithium-ion cells, carbon fibers are suitable as electrodes due to their mechanical properties and ease of intercalation of lithium ions. Carbon fibers have high stiffness and strength and provide mechanical reinforcement and favorable electrical conductivity for transporting electrons into and out of the cell. A polymer, e.g. glass fiber reinforced, can be used as a separator for transporting ions between electrodes to bind the fibers and form a composite battery. For example, EP 2 852 990 B1 describes the fabrication and use of such battery cells in various structural components.

An important question that arises in this regard is how to monitor the charging state of such a structural composite battery. Electrical cables could be integrated in and/or connected to the composite battery in order to perform sequential measurements of the voltage across the electrodes, which could then serve as the basis for an evaluation of the current state of charge.

Recent studies indicate that the color of an electrode layer may change during discharging due to the changing states of lithiation in the respective electrode, e.g. in case of a lithium-ion battery based on LiFeP04, see for example Shellikeri et al., "Investigation of Pre-lithiation in Graphite and Hard-Carbon Anodes Using Different Lithium Source Structures," Journal of The Electrochemical Society, pp. A3914-A3924, Vol. 164, 2017. These studies show that this effect originates from changes in the optical properties of the lithiated compounds as more and more Li is inserted into the respective structures.

Against this background, it is an object of the present invention to find practical and lightweight solutions for assessing the charging state of a structural battery.

This object is achieved by a structural battery having the features of claim 1 and an aircraft or spacecraft having the features of claim 10.

According to the invention, a structural battery for a vehicle, in particular an aircraft or spacecraft, comprises a multi-layer fiber-composite laminate configured as an electrochemical energy storage for storing electrical energy in a rechargeable manner, wherein the laminate comprises a cathode layer, an anode layer and a separator layer separating the cathode layer from the anode layer in a permeable manner for ions transporting electric charge between the cathode layer and the anode layer, wherein the separator layer contains sensing glass fibers arranged adjacent to at least one of the cathode layer and the anode layer; and a charge state monitoring device optically coupled to the sensing glass fibers of the separator layer to readout light signals traveling through the sensing glass fibers, wherein the charge monitoring device is configured to determine a color of at least one of the cathode layer and the anode layer adjacent to the sensing glass fibers based on the readout light signals and to assess a charge state of the electrochemical energy storage based on the determined color.

Further according to the invention, an aircraft or spacecraft has a structural battery according to the invention, wherein the multi-layer fiber-composite laminate of the structural battery forms at least a portion of a structural component of the aircraft or spacecraft.

Thus, one idea of the present invention is to monitor the charging state of a structural composite battery by means of glass fibers integrated in the separator layer bordering the electrodes. The glass fibers transport light signals that are sensitive to a change in color and/or shading of the electrodes, which in turn depends on the chemical composition and status of the electrodes. For example, the color of an electrode may vary depending on the incorporation of certain ions in the electrode (lattice) structure. These changes in color are visible and thus can be detected by the optical fibers.

As a consequence, separate electrical cables for the readout of electrode voltages can be omitted to save weight and space. This also means that consecutive readings of voltage levels would not be necessary for obtaining the charge state. In principle, it is possible to utilize glass fibers that are anyway already provided in the separator layer for other purposes, e.g. as electrical separators and/or as structural reinforcements. In that sense, the presently used glass fibers may be multi-functional. The presently followed optical sensing approach is not vulnerable to electromagnetic disturbances and thus provides outstanding electromagnetic compatibility. Moreover, the present approach allows to determine the charging state reliably even in case of complex arrangements of structurally integrated batteries in parallel and/or linear connections.

Advantageous embodiments and improvements of the present invention are found in the subordinate claims.

According to an embodiment of the invention, the sensing glass fibers may be the optical cores of optical fiber cables running from the charge monitoring device to the separator layer.

Optical fiber cables typically comprise an optical glass fiber core for transmitting light signals having a high refraction index and an outer glass layer, cladding and/or mantle having a lower refraction index than the core to keep the light signals inside the core even when the entire cable, which is flexible, is bent around objects. A light signal sent in to the cable at one end can be readout at the respective other end after having passed through the length of the cable and after having been reflected various times at the border between the core and the mantle. The outer glass layer may additionally be surrounded by a cover and/or protection layer providing protection against moisture and mechanical influences amongst others.

In the present case, optical fiber cables with glass mantle and core can be used as sensing elements within the structural battery. In this case, the mantle and core may contribute to the functions of the separator layer, that is, they may serves as structural and electrical separators between the electrodes. Outside the separator layer, the cables may be provided with an additional protective mantle to protect the fibers against mechanical influences, for example.

According to an embodiment of the invention, the sensing glass fibers may be sheathed by a protective glass mantle outside the separator layer and unsheathed within the separator layer.

Hence, optical fiber cables may connect the charge state monitoring device with the composite laminate, which are stripped of their protective mantle and potentially also their outer glass layer at the borders of the separator layer such that within the laminate only the optical fiber cores of the cables remain. The outer glass mantle may not be necessary within the laminate because the light signals may be kept within the glass core due to reflection at the borders between the core and the surrounding material of the separator layer and the electrodes.

According to an embodiment of the invention, the separator layer may further comprise structural glass fibers for reinforcement of the multi-layer fiber-composite laminate.

Hence, the separator layer may, for example, comprise structural glass fibers embedded in a polymer matrix for mechanical stiffness and rigidity. This structure may then be interspersed with sensing glass fibers, e.g. fiber cores or sheathed optical glass cables.

According to an embodiment of the invention, the sensing glass fibers may have substantially the same diameter as the structural glass fibers and are arranged to structurally reinforce the multi-layer fiber-composite laminate.

The sensing glass fibers may thus be multifunctional and provide structural rigidity and stiffness at the same time (as well as electrical separation between the electrodes). Thus, the present solution does not only avoid any weakening of the laminate structure (in contrast to conventional cables), but may even strengthen and reinforce it.

According to an embodiment of the invention, the sensing glass fibers may be provided in pairs, wherein one glass fiber of each pair serves as receiving optical fiber and the respective other glass fiber of each pair serves as transmitting optical fiber.

In principle, optical signals only require a small space for transport and can be transmitted in multitudes along the same core and moreover be transmitted and received within the same cable. However, it may be challenging to transmit and receive the signals at the same time based on the usual small dimensions. Therefore, transmitted and received signals may be separated from each other and pairs of optical lines may be provided ("duplex optical cables"), in which one line serves as transmitting line and the other as receiving line. These pairs may then be arranged throughout the separator layer. The charge state monitoring device may correspondingly comprise a transmitting unit and a receiving unit coupled to the respective ends of the optical lines.

According to an embodiment of the invention, the cathode layer and/or the anode layer may comprise lithium, wherein a change in color of the respective layer reflects a change in lithiation state of the respective layer.

As mentioned before, experimental tests have shown that the color of an electrode layer with lithium in a lithium-ion battery changes color during charging/discharging, which is due to the change in its lithiation state (number of attached lithium ions). For example, the respective electrode may get darker and/or brighter depending on its lithiation state, which then can be sensed by the optical fibers.

According to an embodiment of the invention, the cathode layer and/or the anode layer may comprise carbon fibers coated with LiFePO4.

The glass fibers are thus able to sense a gradual change in color of the electrode fibers being covered by LiFePO4. Since both cathode and anode may be lithiated or de-lithiated, the effect can be used for either one.

According to an embodiment of the invention, the charge state monitoring device may comprise a color spectrometer configured to analyze the color of the electrode layers based on the readout light signals.

For example, the separator layer may be interspersed with optical fiber pairs of transmitting and receiving fibers, which are coupled to a transmitter/receiver of the charge state monitoring device. The received signals may be forwarded from there to the color spectrometer, which in turn may be connected to a computing system on board of the vehicle for further evaluation. The received signals may be transformed amongst others into an image of the respective electrode, representing its color and/or saturation and indicating a corresponding state of charge.

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. In the figures, like reference numerals denote like or functionally like components, unless indicated otherwise.

Fig. 1 schematically depicts a perspective view of a structural battery according to an embodiment of the invention.

Fig. 2 schematically depicts perspective views of the structural battery of Fig. 1 for three different charge states.

Fig. 3 schematically shows an aircraft equipped with the structural battery of Figs. 1 and 2.

Although specific embodiments are illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein.

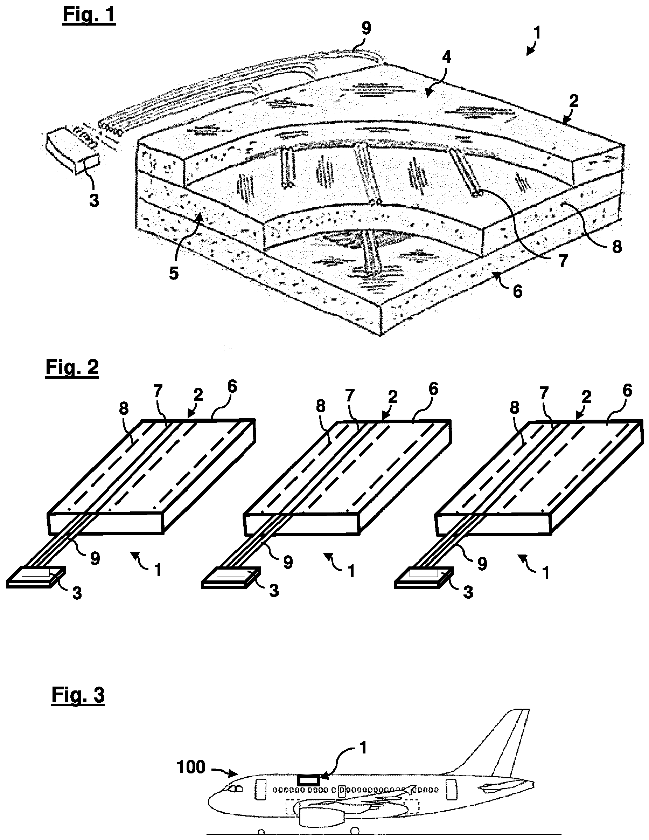

Figure 1 schematically depicts a perspective view of a structural battery 1 according to an embodiment of the invention. The structural battery 1 may form a portion of a structural component of a vehicle, e.g. the passenger aircraft 100 shown in Fig. 3.

The structural component may in particular be a structural component of a primary structure of the aircraft 100 such as, for example, a supporting, connecting and/or stiffening element of a fuselage and/or a wing spar, e.g. a frame, a stringer, a cross member, a beam, a skin field segment, a connecting element or the like. A wide variety of geometric curved or non-curved shapes are conceivable here, as are known to the skilled person from vehicle construction. Purely by way of example, the structural component may be rod-shaped, possibly with a specific transverse profile such as L, T, Z, etc., or plate-shaped/flat. In principle, structural batteries and components as described below can be used not only in aircraft, but also in general aircraft or other applications from the transport industry, e.g. in land, water or rail vehicles.

The structural component is formed based on a multi-layer fiber composite laminate 2 from a plurality of fiber composite layers, as is known to the skilled person in principle from aircraft construction for the manufacture of structural components. In other words, the layers of this laminate structure form the load-bearing structure of the component. For this purpose, the fiber composite laminate 2 comprises a plurality of fiber reinforcement layers made of different fiber materials (e.g. carbon, aramid and/or glass fibers), which are embedded in respective matrix materials (e.g. synthetic resin). Each of these layers may have a structurally stabilizing effect. In addition, some layers may also serve various additional functions.

In the present case, the multi-layer fiber-composite laminate 2 is configured as an electrochemical energy storage for storing electrical energy in a rechargeable manner. In other words, an electro-chemical fiber composite battery is structurally integrated into the structural component and manufactured together with it. This means that the load-bearing structure of the aircraft 100 can store energy as well as retrieve and make it available for use, e.g. for electrical consumers in a passenger cabin, in a cockpit or in a cargo compartment of the aircraft 100 and/or for an electrical drive of the aircraft 100.

In recent decades, structural applications using laminated composite materials have increased in the aerospace field. In this context, laminated composite structures consist of layers of orthotropic materials. Advantages of using fiber-reinforced composites over conventional materials include lower self-weight, high specific strength, excellent fatigue resistance, high stiffness-to-weight ratio, and design flexibility.

Structural batteries can include, for example, carbon fibers as the anode (e.g., embedded in a suitable bonding polymer), a cathode of coated carbon fibers (e.g., LiFePO4 coated, i.e., with lithium metal oxide-based particles, and also embedded in a suitable structural electrolyte polymer), a separator with embedded glass fibers for separating the electrodes and transporting the ions further, a suitable electrolyte material (e.g., a polymerized vinyl ester derivative of a poly(ethylene glycol) electrolyte), and current collectors or current collectors for connection to an external circuit (e.g., additively applied layers/coatings of a metal material). Because of its integrated ability to store energy, such a combination of materials offers significant weight savings at the system level. For structural composite batteries, carbon fibers are particularly suitable due to their mechanical properties and ease of intercalation of lithium ions as electrodes. Carbon fibers have high stiffness and strength, which provide mechanical reinforcement and favorable electrical conductivity for transporting electrons into and out of the battery (cell).

In the exemplary embodiment of Fig. 1, the laminate 2 has a stacked structure comprising a cathode layer 4, an anode layer 6 and a separator layer 5 separating the cathode layer 4 from the anode layer 6 in a permeable manner for ions transporting electric charge between the cathode layer 4 and the anode layer 6. The anode layer 6 may for example include carbon fibers embedded in a structural solid electrolyte (e.g., lithium ion-enriched resin). The cathode layer 4 may also include carbon fibers, e.g. LiFePO4 coated and also embedded in a solid-state electrolyte. The electrode layers 4, 6 may be contacted by corresponding contact elements and/or current conducting layers, which can be made of a metal, e.g. aluminum, copper foil, etc. (not shown here for simplicity).

The separator layer 5 contains structural glass fibers 8, which do not only reinforce the laminate 2 but are also electrically insulating and, in combination with a corresponding matrix material (e.g. synthetic resin), separate the electrodes 4, 6 of the fiber composite laminate 2 from one another. It is to be understood here, that the orientation of the fibers shown in this and the other figures is purely schematic. The person of skill will readily conceive based on the general knowledge how to arrange the reinforcing and functional fibers in the best vein to achieve the presently described technical effects.

Overall, the above leads to the fact that the structural component(s) of the aircraft 100 can be provided with integrated energy storage capabilities (structural batteries) without the need for wiring or connections, since this can be regulated via the integrated energy transmission and suitable control and monitoring devices. This provides structural energy storage and supply with rapid charging and discharging capability without the need for connections, wiring, harnesses and the installation effort usually associated with the assembly of these.

In addition, the separator layer 5 comprises sensing glass fibers 7 arranged adjacent to the cathode layer 4 and/or the anode layer 6. For example, the sensing glass fibers 7 may directly border the electrode layers 4, 6 at the top and bottom of the separator layer 5 and thus the lithiated and/or de-lithiated carbon fibers of these layers. The sensing glass fibers 7 are provided in pairs, one glass fiber 7 of each pair serving as receiving optical fiber and the respective other glass fiber 7 of each pair serves as transmitting optical fiber. The glass fibers 7 may be provided unsheathed within the separator layer 5 and may form the optical cores of optical fiber cables 9, which extend outside the composite laminate 2 and may be provided there with the usual protective cladding and glass mantle known to the person of skill.

The structural battery 1 further comprises a charge state monitoring device 3 optically coupled to the sensing glass fibers 7 of the separator layer 5 to readout light signals traveling through the sensing glass fibers 7. More specifically, the charge monitoring device 3 is configured to determine a color of the cathode layer 4 and/or the anode layer 6 adjacent to the sensing glass fibers 7 based on the readout light signals and to assess a charge state of the electrochemical energy storage based on the determined color. For this purpose, the charge state monitoring device 3 may comprise a color spectrometer configured to analyze the color of the electrode layers 4, 6 based on the readout light signals.

To illustrate this aspect, Fig. 2 schematically depicts perspective views of the structural battery 1 of Fig. 1 for three different charge states. The figure indicates the color change of an electrode during (dis-) charging (in this case, the anode 6 is chosen as an example). More specifically, the lithiation state in this example implies a change in color from dark to bright during discharge of the anode 6 (e.g. from 100% charge on the left, to 50% in the middle and from there to 10% on the right). Since the lithiation state of the carbon fibers in the electrodes 4, 6 reflects the charging state, the charging state can be sensed by the sensing fibers 7. At this point the transmitted signal will hit a surface belonging to the respective electrode 4,6, colored according to the local lithiation state. Since the surface will be porous to some extent, at least least some signals will be reflected so as to hit the receiving sensing fiber 7, which means that the light signal within the fiber 7 will contain information on the color of the reflecting surface. Furthermore, in the lamination process, in which the laminate 2 is placed under pressure during manufacturing, some electrode material may be located in front of the sensing fibers' 7 ends.

The respective signals are transported through the sensing fibers 7 inside the laminate 2. Outside the laminate 2, the sensing fibers 7 are embedded in the protective mantles of the optical fiber cables 9, which allow to transfer the signals to the monitoring device 3 without any further influence on the signal, and thus the information on the electrode color decoded within the respective signal.

Over the extension of the battery 1, the sensing glass fibers 7 may also serve as an electrical separator between the electrodes 4, 6 and may furthermore also reinforce the whole structure in a similar vein as the structural glass fibers 8. In fact, both glass fiber types may be configured similarly, e.g. with the same diameter. In that sense, the sensing glass fibers 7 are multi-functional as they fulfill a tri-functional task: sensing, electrical separation and structural reinforcement. To this end, the sensing glass fibers 7 may be unsheathed within the laminate 2, that is, without glass mantle (e.g. in case of flat laminates where the fibers 7 are not bent). However, it is also possible to provide the sensing fibers 7 with a glass mantle within the laminate 2 as it is known from optical cables.

Thus, as a result, a structural battery 1 is provided with a charge monitoring function without having to compromise on the weight, complexity or structural integrity of the underlying laminate.

In the foregoing detailed description, various features are grouped together in one or more examples or examples with the purpose of streamlining the disclosure. It is to be understood that the above description is intended to be illustrative, and not restrictive. It is intended to cover all alternatives, modifications and equivalents. Many other examples will be apparent to one skilled in the art upon reviewing the above specification. The embodiments were chosen and described in order to best explain the principles of the invention and its practical applications, to thereby enable others skilled in the art to best utilize the invention and various embodiments with various modifications as are suited to the particular use contemplated.

### List of reference signs

- 1: structural battery
- 2: multi-layer fiber-composite laminate
- 3: charge state monitoring device
- 4: cathode layer
- 5: separator layer
- 6: anode layer
- 7: sensing glass fiber
- 8: structural glass fiber
- 9: optical fiber cable
- 100: aircraft

## Claims

1. Structural battery (1) for a vehicle, in particular an aircraft (100) or spacecraft, comprising:
a multi-layer fiber-composite laminate (2) configured as an electrochemical energy storage for storing electrical energy in a rechargeable manner,
wherein the laminate (2) comprises a cathode layer (4), an anode layer (6) and a separator layer (5) separating the cathode layer (4) from the anode layer (6) in a permeable manner for ions transporting electric charge between the cathode layer (4) and the anode layer (6), wherein the separator layer (5) contains sensing glass fibers (7) arranged adjacent to at least one of the cathode layer (4) and the anode layer (6); and
a charge state monitoring device (3) optically coupled to the sensing glass fibers (7) of the separator layer (5) to readout light signals traveling through the sensing glass fibers (7), wherein the charge monitoring device (3) is configured to determine a color of at least one of the cathode layer (4) and the anode layer (6) adjacent to the sensing glass fibers (7) based on the readout light signals and to assess a charge state of the electrochemical energy storage based on the determined color.

2. Structural battery (1) according to claim 1, wherein the sensing glass fibers (7) are the optical cores of optical fiber cables (9) running from the charge monitoring device (3) to the separator layer (5).

3. Structural battery (1) according to claim 1 or 2, wherein the sensing glass fibers (7) are sheathed by a protective glass mantle outside the separator layer (5) and unsheathed within the separator layer (5).

4. Structural battery (1) according to one of the claims 1 to 3, wherein the separator layer (5) further comprises structural glass fibers (8) for reinforcement of the multi-layer fiber-composite laminate (2).

5. Structural battery (1) according to one of the claims 1 to 4, wherein the sensing glass fibers (7) have substantially the same diameter as the structural glass fibers (8) and are arranged to structurally reinforce the multi-layer fiber-composite laminate (2).

6. Structural battery (1) according to one of the claims 1 to 5, wherein the sensing glass fibers (7) are provided in pairs, wherein one glass fiber (7) of each pair serves as receiving optical fiber and the respective other glass fiber (7) of each pair serves as transmitting optical fiber.

7. Structural battery (1) according to one of the claims 1 to 6, wherein at least one of the cathode layer (4) and the anode layer (6) comprise lithium, wherein a change in color of the respective layer (4, 6) reflects a change in lithiation state of the respective layer (4, 6).

8. Structural battery (1) according to one of the claims 1 to 7, wherein at least one of the cathode layer (4) and the anode layer (6) comprise carbon fibers coated with LiFePO4.

9. Structural battery (1) according to one of the claims 1 to 8, wherein the charge state monitoring device (3) comprises a color spectrometer configured to analyze the color of the electrode layers (4, 6) based on the readout light signals.

10. Aircraft (100) or spacecraft having a structural battery (1) according to one of the claims 1 to 9, wherein the multi-layer fiber-composite laminate (2) of the structural battery (1) forms at least a portion of a structural component of the aircraft (100) or spacecraft.
